(19) Europäisches Patentamt
European Patent Office
Office européen des brevets

(11) **EP 4 202 797 A1**

(12) **EUROPEAN PATENT APPLICATION**

(43) Date of publication:
**28.06.2023 Bulletin 2023/26**

(21) Application number: **22214997.3**

(22) Date of filing: **20.12.2022**

(51) International Patent Classification (IPC):
*G06N 10/40* *(2022.01)*

(52) Cooperative Patent Classification (CPC):
**G06N 10/40**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.12.2021 AU 2021904192
06.09.2022 AU 2022228109**

(71) Applicant: **Silicon Quantum Computing Pty Ltd
Kensington, NSW 2052 (AU)**

(72) Inventors:
  • **Simmons, Michelle Yvonne
    Kensington, New South Wales, 2052 (AU)**

  • **Gorman, Samuel Keith
    Kensington, New South Wales, 2052 (AU)**
  • **Thorgrimsson, Brandur
    Kensington, New South Wales, 2052 (AU)**
  • **Kranz, Ludwik
    Kensington, New South Wales, 2052 (AU)**
  • **Keith, Daniel
    Kensington, New South Wales, 2052 (AU)**
  • **Chung, Yousun
    Kensington, New South Wales, 2052 (AU)**

(74) Representative: **Grünecker Patent- und
Rechtsanwälte
PartG mbB
Leopoldstraße 4
80802 München (DE)**

(54) **SYSTEMS AND METHODS FOR INITIALIZING AND MEASURING QUBITS**

(57)    A method for measuring the spin of an electron in a quantum dot that is tunnel coupled to a reservoir is disclosed. The method includes measuring a spin state of the injected electron while applying a ramped detuning for a time period.

Fig. 1A

EP 4 202 797 A1

**Description**

## TECHNICAL FIELD

Aspects of the present disclosure are related to advanced processing systems and more particularly, to quantum processing systems and to methods and systems for initializing and measuring processing elements in such quantum processing systems.

## BACKGROUND

The developments described in this section are known to the inventors. However, unless otherwise indicated, it should not be assumed that any of the developments described in this section qualify as prior art merely by virtue of their inclusion in this section, or that those developments are known to a person of ordinary skill in the art.

Large-scale quantum processing systems hold the promise of a technological revolution, with the prospect of solving problems which are out of reach with classical machines.

To date, a number of different structures, materials, and architectures have been proposed to implement quantum bits (or qubits) and corresponding quantum control and processing systems.

Before such large-scale quantum computers can be manufactured commercially, a number of hurdles need to be overcome. Precise measurement of qubit states at any given time in a quantum processing device is one such essential requirement. Different types of sensors and qubit measurement and initialization techniques have been proposed in the art. Some of these techniques however may be prone to errors.

Accordingly, improved techniques for measuring qubit states and/or initializing qubits in quantum processing systems are desirable.

Reference to any prior art in the specification is not an acknowledgment or suggestion that this prior art forms part of the common general knowledge in any jurisdiction or that this prior art could reasonably be expected to be understood, regarded as relevant, and/or combined with other pieces of prior art by a skilled person in the art.

## SUMMARY

According to a first aspect of the present disclosure there is a provided a method for measuring the spin of an electron in a quantum dot that is tunnel coupled to a reservoir. The method includes measuring a spin state of the injected electron while applying a ramped detuning for a time period.

In some embodiments, the method further includes emptying the quantum dot.

The method may further include injecting an electron in the quantum dot by applying a constant voltage pulse for a first time period.

In some embodiments, applying the ramped detuning includes continuously ramping electrochemical potentials of the spin states of the injected electron from below the Fermi energy of the reservoir to above the Fermi energy of the reservoir.

In some embodiments, measuring the spin state of the injected electron includes monitoring a charge signal of the quantum dot using a charge sensor.

Further, a blip in the charge signal of the quantum dot before a threshold time may indicate a spin-up state of the injected electron. Alternatively, an increase in the charge signal of the quantum dot after a threshold time may indicate a spin-down state of the injected electron.

In some embodiments, a rate for the injected electron to tunnel out of the quantum dot and into the reservoir increases during the time period and a rate for an electron to tunnel from the reservoir to the quantum dot decreases during the time period.

According to a second aspect of the present disclosure, there is provided a method for initializing a spin qubit in a quantum dot that is tunnel coupled to a reservoir. The method includes injecting an electron in the quantum dot by applying a ramped detuning for a first time period.

In some embodiments, the method further includes emptying the quantum dot.

In some embodiments, the method further includes measuring a spin state of the injected electron while applying a ramped detuning for a second time period

Applying the ramped detuning for the first time period may include continuously ramping electrochemical potentials of the spin states of the injected electron from above the Fermi energy of the reservoir to below the Fermi energy of the reservoir.

In some embodiments, the spin state of the injected electron comprises monitoring a charge signal of the quantum dot using a charge sensor.

In some embodiments, a spin state of the injected electron depends on a rate of the ramped detuning.

In some embodiments, the electron has a spin-down state in response to a slow rate of the ramped detuning.

The method further includes the step of selecting the first time period to control the relative population of the two spin states.

According to a third aspect of the present disclosure, there is provided a method for measuring the spin of an electron in a first quantum dot that is tunnel coupled to a second quantum dot. The measure includes measuring a quantum state of the first and second quantum dots while applying a ramped detuning for a time period.

In some embodiments, the method further includes injecting an electron in the second quantum dot to set the state of the quantum dots to a singlet state such that the first quantum dot includes zero unpaired electrons and the second quantum dot includes two electrons by applying a constant voltage pulse for a first time period.

In some embodiments, the method further includes applying the ramped detuning comprises continuously ramping electrochemical potentials of the spin states of the injected electron from below Fermi energy to above the Fermi energy.

In some embodiments, the method further includes measuring the quantum state of the first and second quantum dots comprises monitoring a charge difference between the first and second quantum dots using a charge sensor.

The method further includes a step in the charge difference between the quantum dots before a threshold time indicates a singlet quantum state.

The method further includes an increase in the charge difference between the quantum dots after a threshold time indicates a triplet zero quantum state.

The method further includes a rate for the injected electron to tunnel out of the second quantum dot and into the first quantum dot increases during the time period.

According to a third aspect of the present disclosure there is provided a method for measuring the spin of an electron in a first quantum dot that is tunnel coupled to a quantum element, the method includes: measuring a quantum state of the first quantum dot while applying a ramped detuning for a time period.

In some embodiments, the quantum element may be a reservoir and measuring the quantum state of the first quantum dot includes measuring a spin state of the electron. In other embodiments, the quantum element may be a second quantum dot, and measuring the quantum state of the first quantum dot includes also measuring the quantum state of the second quantum dot.

In some embodiments, the method further includes injecting an electron in the second quantum dot to set the state of the quantum dots to a singlet state such that the first quantum dot includes zero unpaired electrons and the second quantum dot includes two electrons by applying a constant voltage pulse for a first time period.

It will be appreciated that applying the ramped detuning comprises continuously ramping electrochemical potentials of the spin states of the injected electron from below Fermi energy to above the Fermi energy. Further, measuring the quantum state of the first and second quantum dots comprises monitoring a charge difference between the first and second quantum dots using a charge sensor, and where: a step in the charge difference between the quantum dots before a threshold time indicates a singlet quantum state; and an increase in the charge difference between the quantum dots after a threshold time indicates a triplet zero quantum state.

Further still, a rate for the injected electron to tunnel out of the second quantum dot and into the first quantum dot increases during the time period.

## BRIEF DESCRIPTION OF DRAWINGS

While the invention is amenable to various modifications and alternative forms, specific embodiments are shown by way of example in the drawings and are described in detail. It should be understood, however, that the drawings and detailed description are not intended to limit the invention to the particular form disclosed. The intention is to cover all modifications, equivalents, and alternatives falling within the spirit and scope of the present invention as defined by the appended claims.

Figs. 1A and 1B show the principle of spin-to-charge conversion.

Fig. 1C is a chart showing charge sensed by a charge sensor when an electron remains in a quantum dot and does not tunnel to a reservoir.

Fig. 1D is a chart showing charge sensed by a charge sensor when an electron tunnels from a quantum dot to a reservoir.

Fig. 1E illustrates the voltage pulses used during the three stages of energy-selective measurement (ESM) to align the electrochemical potentials of the electron spins relative to the Fermi-level of the reservoir $E_F$.

Fig. 1F is a schematic illustrating the electrochemical potential for ESM during the three stages of ESM.

Fig. 1G is a chart showing signal detected from a nearby charge sensor during ESM.

Fig. 2 shows a scanning tunnel microscope (STM) image of an example quantum device in which aspects of the present disclosure can be implemented.

Fig. 3 is a flowchart illustrating an example ramped spin measurement (RSM) method for measuring spin according to some aspects of the present disclosure.

Fig. 4A shows the voltage pulses used during the RSM method.

Fig. 4B is a chart illustrating signal detected from a nearby charge sensor during RSM.

Fig. 5A shows spin-tail measurement performed on the quantum device of Fig. 2 and the corresponding parameters.

Fig. 5B illustrates example readout traces of RSM.

Fig. 5C illustrates a histogram of the RSM time traces shown in Fig. 5B.

Fig. 5D illustrates ramped spin measurement time traces for 1000 experimental repetitions of RSM while initializing a random spin and a moving average of the position of the spin-down peak. Fig. 6A shows the probability distributions and fidelities for the spin-up and spin-down for RSM.

Fig. 6B shows the visibility and optimal ramp measurement time for RSM.

Fig. 6C shows the visibility for RSM, and ESM for an optimised detuning $\varepsilon$, and $\varepsilon = 0$ as a function of $\gamma_e B/k_B T_e$.

Fig. 6D shows the optimal measurement time for RSM, optimised detuning ESM, and ESM with detuning $\varepsilon = 0$ as a function of $\gamma_e B/k_B T_e$.

Fig. 7 is a flowchart illustrating an example method for initializing a qubit using ramped spin initialization according to aspects of the present disclosure.

Fig. 8 illustrates the ramped protocol for initializing an electron spin-down state of a quantum dot.

Fig. 9A shows experimentally measured spin-up fraction as a function of ramp time for the initialization method.

Fig. 9B shows the final spin probabilities after the ramped initialization as a function of the relative ramp rate.

Fig. 10A and 10B depict the principle of spin state selective tunnelling between two quantum dots.

Fig. 10C is a chart showing charge difference between two quantum dots when an electron remains on the first dot.

Fig. 10D is a chart showing charge difference between two quantum dots when an electron from a first quantum dot tunnels to a second quantum dot.

Fig. 10E illustrates the states of the quantum dots during the three stages of spin-selective measurement.

Fig. 10F is a schematic illustrating the energy difference between singlet and triplet states of two quantum dots during three stages of spin-selective measurement.

Fig. 11A a schematic illustrating the energy difference between singlet and triplet states of two quantum dots during three stages of RSM between two quantum dots.

Fig. 11B illustrates the states of the quantum dots during the three stages of RSM between two quantum dots.

Fig. 12 is a flowchart illustrating an example ramped spin measurement (RSM) method for measuring spin using two quantum dots.

Fig. 13 illustrates the voltage pulses used during three stages of spin-selective RSM using a non-linear ramped voltage.

## DETAILED DESCRIPTION

The spin states of electrons or nuclei in a semiconductor material are good candidates to carry quantum information and act as quantum bits (or qubits) for a quantum computing system. In order to perform quantum computation however three important steps are required - initialization of qubits, control of qubits, and readout of individual qubits. This present disclosure provides new and improved techniques for two of these steps - qubit initialization and measurement (also referred to as readout in this disclosure).

### Energy-selective measurements

Single-shot spin readout is an important requirement for error-corrected quantum computing in semiconductor spin qubits.

In some cases, single-shot spin readout is performed by mapping the spin state of a qubit onto a charge state (i.e., spin-to-charge conversion), which can then be detected using a nearby charge sensor such as a single-electron transistor (SET), a single-lead quantum dot (SLQD) charge sensor, a quantum point contact (QPC), a tunnel junction, or a single lead sensor.

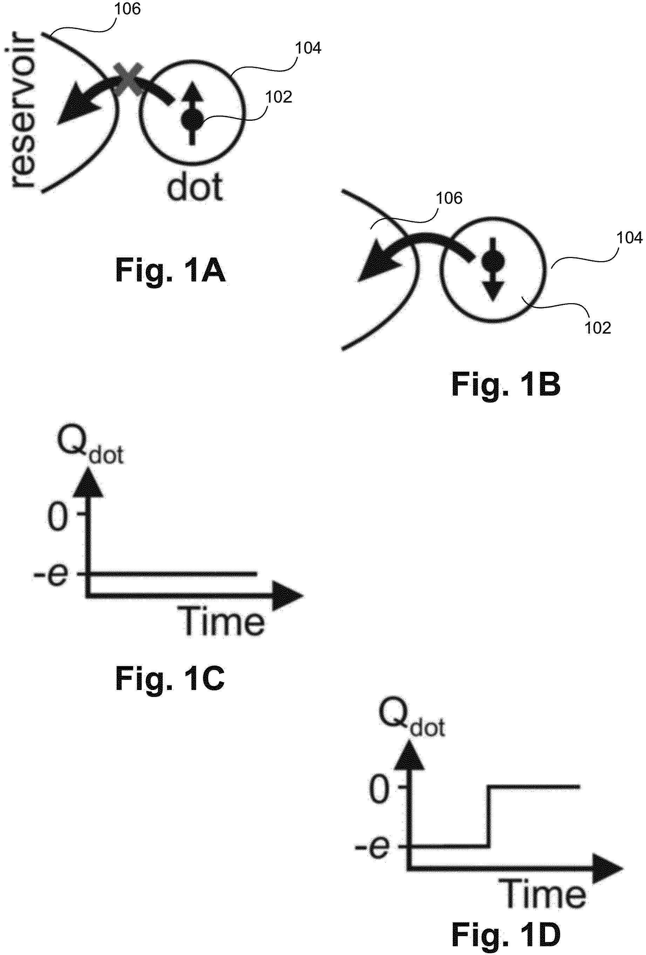

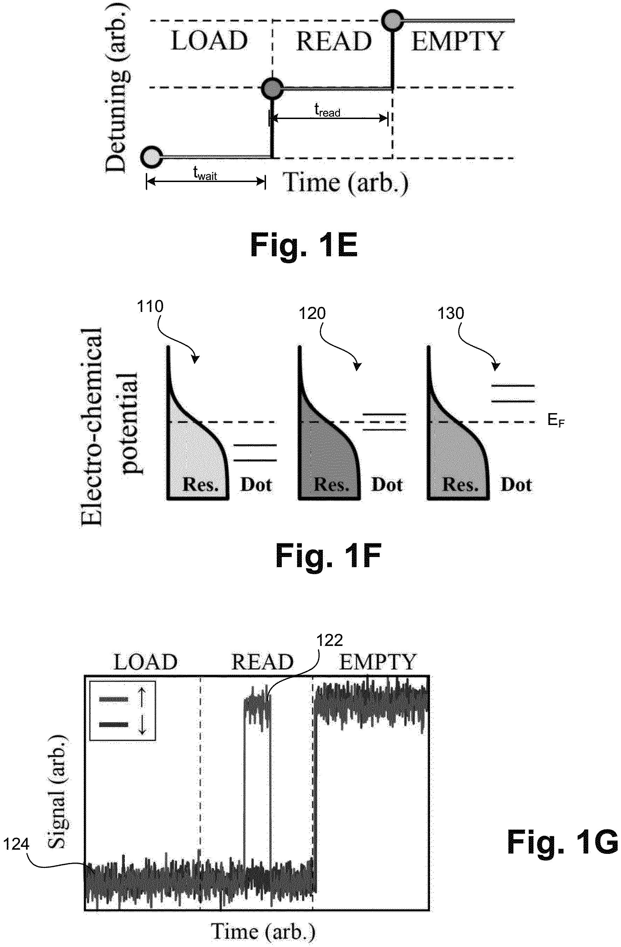

One such single-shot readout technique is referred to as energy-selective measurement (ESM). Fig. 1 schematically shows this measurement technique. In particular, Figs. 1A and 1B depict a single electron spin 102 confined in a quantum dot 104. In Fig. 1A, the electron has a spin-up ($|\uparrow\rangle$) state and in Fig. 1B the electron 102 has a spin-down ($|\downarrow\rangle$) state. In ESM, a magnetic field ($B_0$) is applied to split the spin-up and spin-down states by the Zeeman energy. The quantum dot potential is then tuned such that if the electron has spin-down (as seen in Fig. 1B), the electron 102 leaves the quantum dot 104 and returns to a reservoir 106, whereas it will stay on the quantum dot 104 if it has spin-up (as seen in Fig. 1A). Figs. 1C and 1D are charts showing the charge state of the quantum dot 104 as a function of time as detected by a nearby charge sensor (not shown). If the electron remains in the quantum dot after the dot potential has been tuned, the charge of the quantum dot 104 remains the same over a period of time (see shown in Fig. 1C). Alternatively, if the electron tunnels to the reservoir 106 after the dot potential has been tuned, the change is noticed in the charge of the quantum dot (see the charge of the quantum dot increase after a period of time in Fig. 1D). In this manner, the spin state is correlated with the charge state, and measurement of the charge on the dot reveals the original spin state.

The above description of the ESM techniques is described with reference to a system where the spin-up electron has lower energy than the spin-down electron. For example, the measurement technique may be performed in a GaAs (Gallium arsenide) material. In this case, the lower-energy spin-up electron cannot tunnel to the reservoir. In other examples, the spin-up state has higher energy compared to the spin-down state. For example, in a silicon material. In these examples, the spin-down state cannot tunnel to the reservoir.

In some cases, to measure the spin of a qubit using ESM a three stage process (as shown in Fig. 1F) is used that includes: a first stage 110 in which the quantum dot 104 is emptied, a second stage 120 in which one electron 102 with an unknown spin is injected in the quantum dot 104 and a third stage 130 in which the spin state is measured (using a nearby charge sensor). The different stages are typically controlled by a three-level voltage pulse on a nearby gate. The voltage pulse shifts the quantum dot's energy levels around the Fermi level, $E_F$, of the tunnel coupled reservoir 106. Fig. 1E shows the shape of the voltage pulse applied to the gate. Before a pulse is applied, the quantum dot 104 is empty, as both the spin-up and spin-down energy levels are above the Fermi energy of a nearby reservoir, $E_F$. Then at stage 110 a voltage pulse (called the load phase) is applied for time $t_{wait}$. This pulse pulls the energy levels of both spin states below $E_F$. An electron 102 can now energetically tunnel into the dot 104 from the reservoir 106. The particular electron can have spin-up or spin-down. During this stage 110, the electron 102 is trapped on the dot 104 and Coulomb blockade prevents a second electron from being added to the dot 104. After $t_{wait}$, the voltage pulse is reduced and maintained for a duration $t_{read}$, in order to position the energy levels of the spin-up and spin-down states in a read-out configuration. If the electron spin is $|\downarrow\rangle$, its electrochemical potential, $\mu_{0\leftrightarrow\downarrow}$ is below $E_F$, so the electron remains on the dot. If the spin is $|\uparrow\rangle$, its electrochemical potential, $\mu_{0\leftrightarrow\uparrow}$ is above $E_F$, so the electron tunnels to the reservoir 106. Now Coulomb blockade is lifted and an electron with spin-up can tunnel onto the dot 104. After $t_{read}$, the pulse ends and the dot is emptied again.

In the read phase, the voltage pulse quickly moves $\mu_{0\leftrightarrow\downarrow}$ and $\mu_{0\leftrightarrow\uparrow}$ such that $E_F$ is situated between them. In this position a spin-up electron is more likely to tunnel out of the quantum dot 104 and to the reservoir 106 compared to a spin-down electron. If a spin-up electron tunnels to the reservoir 106 then a spin-down electron can tunnel onto the quantum dot 104 from the reservoir 106 at this stage.

This two-step tunnelling process creates a 'blip' in a nearby charge sensor response which is a signature that state-to-charge conversion of the electron spin state has been performed. Fig. 1G shows the signal from a nearby sensor during ESM. During the read phase 120, the spin-up state is detected as a characteristic 'blip' 122 in the charge sensor signal 124.

Importantly, the density of states in the reservoir 106 are broadened by an effective electron temperature $T_e$ with an energy, $k_B T_e$ where $k_B$ is Boltzmann's constant. Therefore, there is some finite probability that a detected blip 122 is actually due to a spin-down electron tunnelling to the reservoir 106, which causes the spin-down electron to be counted as a spin-up. These unintentional spin-down tunnel events are the main source of error when performing ESM at small $B_0$ or at high temperatures.

The ESM described above has allowed for high-fidelity electron spin readout. However, the protocol relies on the precise alignment of both the spin-up and spin-down energy levels $\mu_0 \leftrightarrow \downarrow$ and $\mu_0 \leftrightarrow \uparrow$ about $E_F$. The alignment procedure is usually performed by measuring a so-called 'spin-tail' by varying the read level from below $E_F$ to above $E_F$ and then determining the optimal read level by analysing the measurement fidelity. In a large-scale quantum computing architecture such precise alignment may not be feasible for every qubit on a timescale that is allowed by charge noise.

Additionally, ESM requires that the ratio of qubit tunnel rates to be ~ 800 corresponding to Ez > $13 k_B T_e$ when $\mu_0 \leftrightarrow \downarrow$ = -$\mu_0 \leftrightarrow \uparrow$ for high-fidelity readout. However, recent proposals and experiments are investigating the possibility of operating spin qubits at temperatures above 1K to increase cooling power for cryogenic electronics. Therefore, it would be beneficial to have a spin readout technique that can still be used when Ez - $k_B T_e$.

To overcome some of these issues, aspects of the present disclosure provide new qubit readout and initialization methods. These methods are more resilient to charge noise, high-temperatures, and low magnetic field operation. Further, these methods can be easier to scale to a larger number of qubits compared to ESM.

The qubit initialization and measurement methods of the present disclosure are referred to as ramped spin initialization (RSI) and ramped spin measurement (RSM) methods. In the RSM/RSI methods, the tunnel rates of the electron spin states are continuously varied in time rather than being fixed. Further details about the RSI and RSM method will be described in the following sections.

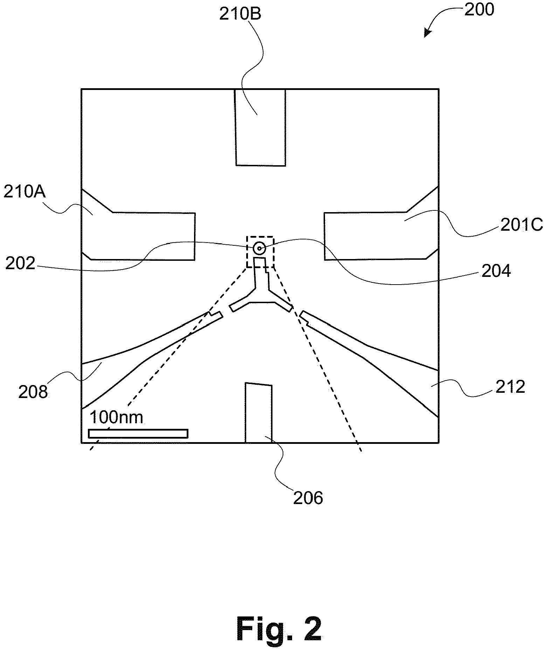

The RSI and RSM methods will be described with respect to donor based quantum processing systems. One such quantum processing device 200 is displayed in Fig. 2. In particular, Fig. 2 shows a scanning tunnelling microscope (STM) image of the device 200 including a quantum dot 202 and an electron 204 that may be tunnelled into the quantum dot under specific conditions.

The whole device 200 may be epitaxial - i.e., the donor dot 202 may be fabricated within a substrate (such as a p-type Si substrate (1-10 Ω cm). Positioning the donor dot 202 epitaxially can significantly reduce impact of noise on the qubit. In some examples, the quantum dot 202 is formed about 20-50nm from the surface.

The quantum dot 202 may be tunnel coupled to a charge sensor 206 (such as a single-electron transistor SET) and electron reservoir 208 to load the electrons 204 onto the donor dot 202. Further, the qubit 212 thus formed may be controlled by one or more gates 210. Fig. 2 illustrates three gates - left gate 210A, middle gate 210B and right gate 210C, which can be used to control the electrochemical potentials of the donor dot 202, whereas the SET gate 206 is predominately used to control the electrochemical potential of the SET. In one implementation, the gates may be metal contacts on the surface. In another implementation, the gates may be phosphorus-doped silicon (SiP) gates fabricated epitaxially within the semiconductor substrate. In either case, the gates allow full electrostatic control of the qubit.

*Ramped spin measurement method*

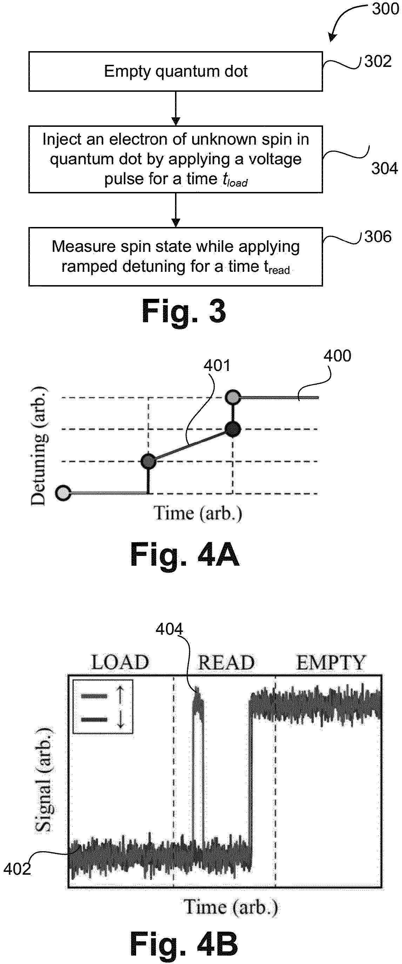

Fig. 3 illustrates an example method 300 for measuring spin qubits based on the ramped spin measurement method of the present disclosure. Like the ESM method, the RSM method 300 includes three steps. At step 302, the quantum dot 202 is emptied. At step 304, one electron 204 with an unknown spin is injected in the quantum dot 202. At step 306, the spin state of the electron 204 is measured. These steps of the RSM method 300 are controlled by applying voltage on a nearby gate 210, which shifts the energy levels of the quantum dot 202 around the Fermi level, $E_F$, of the tunnel coupled reservoir 208.

Fig. 4A shows the shape of the voltage pulse applied to the gate 210 during method 300. As seen in Fig. 4A, the voltage pulse 400 is similar to the voltage pulse applied in the ESM method during the load and empty stages. However, during the read phase (i.e., at step 306), instead of pulsing the voltage to a single detuning value and waiting for the electron spin-up state to tunnel out to the reservoir 208, in the present method 300, the detuning is ramped 401 from below the Fermi energy $E_F$ to above the Fermi energy $E_F$.

Further, the load stage and empty stage are equivalent to the load and empty stages of the ESM method. However, the read phase now involves determining when a blip occurs during the read phase rather than if a blip is detected. Fig. 4B shows a corresponding signal from the charge sensor 206 during RSM. A blip 404 in the charge sensor signal 402 before a certain threshold time indicates the presence of a spin-up electron 204. A blip in the charge sensor signal 402 after the threshold time indicates the presence of a spin-down electron 204. Further, the charge sensor signal 402 reaches its maximum value before the empty phase as the spin-down electron also tunnels out to the reservoir 208 during the read phase.

The ramping 401 of the detuning fundamentally changes the way in which the spin-to-charge conversion process operates in RSM. First, the tunnel rates of the $|\downarrow\rangle$ and $|\uparrow\rangle$ states, $\Gamma_{in/out\downarrow}$ and $\Gamma_{in/out\uparrow}$ respectively, become time-dependent. Specifically, the tunnel out rates are slow at the beginning of the ramp (generally of a few Hz) 401 and then increase over the duration of the ramp while the tunnel in rates are fast at the start of the ramp (generally less than a MHz) 401 and then decrease over time. These time-dependent tunnel rates are the reason that RSM can outperform ESM.

Secondly, in the RSM technique, the time threshold is redefined. For ESM, the time threshold is equivalent to the readout time and is chosen to determine if a blip 122 is detected. If a blip is detected the qubit state is assigned to be $|\uparrow\rangle$, whereas if no blip is detected before the time threshold then the spin state is assigned to be | t). However, for RSM the time threshold is used to threshold when a blip occurs. If a blip 404 is detected before the time threshold then the spin state is assigned to be $|\uparrow\rangle$ and if the blip 404 occurs after then the spin state is assigned as $|\downarrow\rangle$.

Since the electrochemical potentials of both spin states are above $E_F$ at the end of the ramp 401, a blip 404 or step is always detected in the charge sensor signal during the read phase; that is, the electron spin has to be in either $|\uparrow\rangle$ or $|\downarrow\rangle$.

Such a ramp pulse 401 in the read phase is advantageous for a number of reasons. For high temperature or low magnetic field conditions the optimal energy position occurs where both $\mu_{0\leftrightarrow\downarrow}$ and $\mu_{0\leftrightarrow\uparrow}$ are below $E_F$ and the tunnel rates to the electron reservoir 208 are slow. The slow tunnel rates mean that the readout time becomes impractical. Ramped spin measurement mitigates this long readout time that would otherwise be required by attempting readout at every detuning position for a short amount of time. Therefore, in such situations, the spin measurements can achieve high-fidelity while keeping the readout time short.

Additionally, the alignment of the RSM method 300 is comparatively simple and fast over the traditional 'spin-tail' measurement and involves performing the same pulse sequence as for the actual readout protocol.

Finally, the use of ramp pulses 401 significantly reduces the bandwidth requirements for fast pulsing which could possibly lead to lower electron temperatures since additional filtering can be implemented.

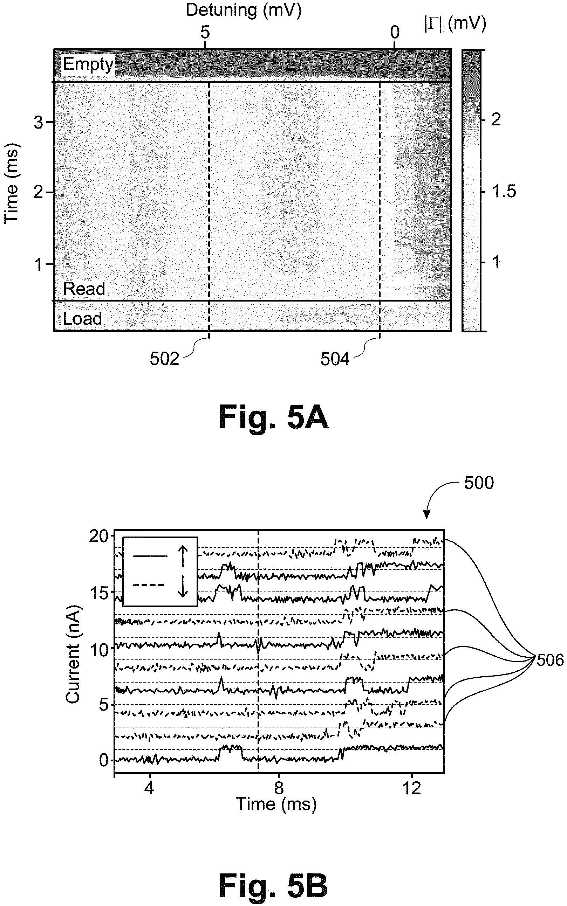

Fig. 5A depicts a 'spin-tail' measurement where the SET signal is measured in time while the read level of the qubit is varied implemented on the device 200. In particular, Fig. 5A depicts the spin-tail measurements where time is plotted along the y-axis and detuning is plotted along the x-axis. The variation in colour in the chart from white to grey indicates the probability of the electron being in spin-up (grey) or spin-down (white). The read level is varied from below $E_F$ (negative voltages) to above $E_F$ (positive voltages). A single electron 204 is loaded onto the quantum dot 202 using an SET which acts as both a charge sensor 206 and electron reservoir 208. Voltage pulse 400 is then applied on the electrical gates 210 to control the electrochemical potentials of the quantum dot 202 while keeping the Fermi-level of the SET constant. The dashed lines 502, 504 show the length of the measured 'spin-tail' where $|\uparrow\rangle$ electrons tunnel to the SET and a $|\downarrow\rangle$ electron tunnels back onto the quantum dot 202, respectively.

For comparison, Fig. 5B shows example single shot traces of the RSM method 300 while initialising a random electron spin state on the same device 200. The solid black lines indicate the spin-up state and the dashed lines 506 indicate the spin-down state. In particular, chart 500 shows the current measured through the SET over the $t_{read}$ time period for multiple experiments for $B_0 = 1T$. For each trace, the time where the first step is detected, $t_d$, is determined and then a histogram is built of $t_d$ for 10,000 experimental repetitions.

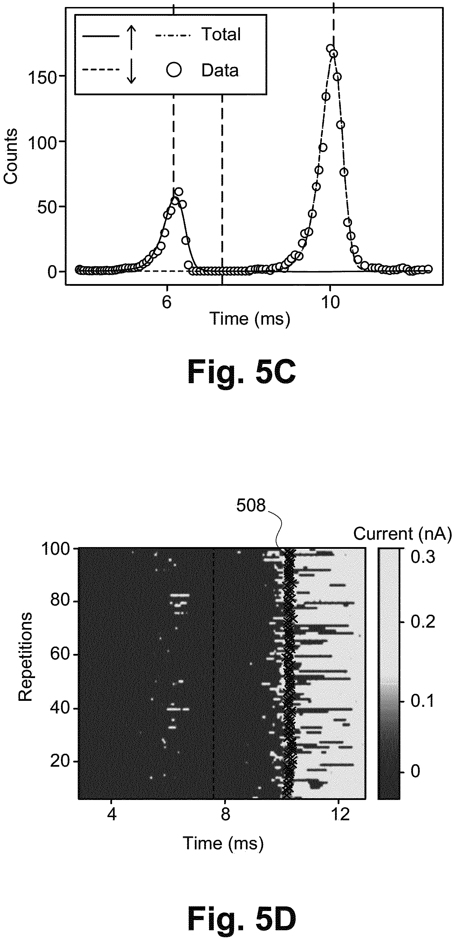

The resulting histogram is shown in Fig. 5C where a clear bimodal distribution can be seen around the 6 and 10ms marks. The two peaks in the histogram correspond to $|\uparrow\rangle$ or $|\downarrow\rangle$ (aligned with the dashed lines in Fig. 5A where the shorter $t_d$ events are associated with a spin up $|\uparrow\rangle$ and the longer events are associated with a spin $|\downarrow\rangle$. Additionally, by monitoring the position of the spin down $|\downarrow\rangle$ distribution using a moving average, the threshold time can be adjusted either in real-time or in post-processing as shown by line 508 in Fig. 5D. This additional analysis makes RSM robust to low-frequency noise during the measurement.

The bimodal distribution of the measured signal in Fig. 5C is non-Gaussian. This non-Gaussianity is due to the time-varying tunnel rates of the spin states which can be modelled as a non-homogeneous Poisson (NHP) process due to the independent nature of electron tunnelling events. The NHP process is defined by a rate function $\lambda(t)$ which describes the probability of an electron tunnelling off the measured qubit at time t having not already tunnelled prior to time t. In this case, tunnelling of an electron from the quantum dot 202 to the reservoir 208 is dictated by a Fermi distribution of temperature $T_e$ corresponding to the effective electron temperature of the reservoir 208.

During RSM, the detuning is ramped across the Fermi broadened electron transition during readout from an initial detuning point $\varepsilon_0$ relative to the centre of the transition with a ramp rate of $r = \varepsilon_{ramp}/t_{ramp}$ where $\varepsilon_{ramp}$ is the change in qubit detuning relative to the reservoir 208, and $t_{ramp}$ is the duration of the ramp 401. The rate function is given by:

$$\lambda(t) = \frac{\Gamma}{\exp\left(-\frac{\epsilon_0 + rt}{k_B \Gamma e}\right) + 1} \tag{1}$$

where $\Gamma$ is the maximum tunnel rate of the electron transition and $k_B$ is the Boltzmann constant.

The tunnelling event distributions during RSM are equivalent to the probability density function (PDF) $f(t)$ which for a NHP process can be calculated as:

$$f(t) = \lambda(t) \exp\left(-\int_0^t \lambda(y)dy\right) \tag{2}$$

Substituting the rate equation from Equation 1 into Equation 2 results in the general normalised PDF for RSM as

$$f^{\uparrow/\downarrow}(t) = \frac{\Gamma \exp(-\Gamma t)}{\exp\left(\frac{\epsilon_0^{\uparrow/\downarrow} + rt}{k_B T_e}\right) + 1} \left(\frac{\exp\left(\frac{\epsilon_0^{\uparrow/\downarrow} + rt}{k_B T_e}\right) + 1}{\exp\left(\frac{\epsilon_0^{\uparrow/\downarrow}}{k_B T_e}\right) + 1}\right)^{\frac{\Gamma k_B T_e}{r}} \tag{3}$$

Using this equation it is possible to analytically model the electron system during RSM.

The fidelity of RSM can be quantified by the spin up and spin down fidelities which are the proportion of electrons correctly identified for each spin state respectively.

Given that for RSM a time threshold is used to distinguish between the two spin states, and hence their respective PDFs, the spin up fidelity can be described in terms of the normalised cumulative density function (CDF) $F^{\uparrow}$ and the spin down fidelity can be described in terms of the CDF $F^{\downarrow}$. In general, for a given time T, the CDF is defined as

$$F(T) = \int_0^T f(t)dt \tag{4}$$

Hence, by substituting in Equation 3, this results in the specific CDF $F(t)$ for RSM as

$$F^{\uparrow/\downarrow}(T) = 1 - \exp(-\Gamma t)\left(\frac{\exp\left(\frac{\epsilon_0^{\uparrow/\downarrow} + rt}{k_B T_e}\right) + 1}{\exp\left(\frac{\epsilon_0^{\uparrow/\downarrow}}{k_B T_e}\right) + 1}\right)^{\frac{\Gamma k_B T_e}{r}} \tag{5}$$

For a given value of the time threshold t, the spin up fidelity is given as $F^{\uparrow}(t)$, and the spin down fidelity is given as $1 - F^{\downarrow}(t)$. The fidelities can then be combined into a single metric, the visibility V as defined by:

$$V(t) = F^{\uparrow}(t) + \left(1 - F^{\downarrow}(t)\right) - 1 \tag{6}$$

$$= F^{\uparrow}(t) - F^{\downarrow}(t) \tag{7}$$

which can be used for optimising the fidelity.

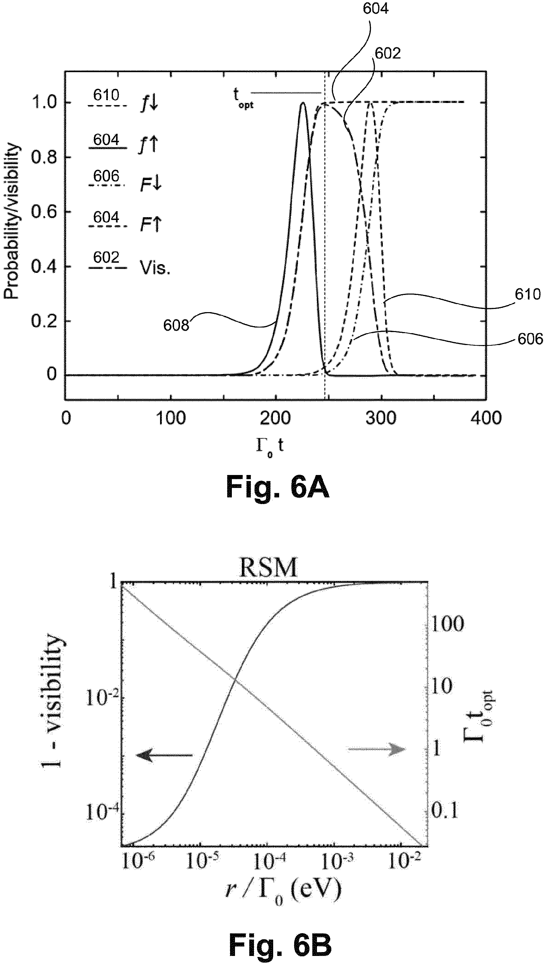

To optimise and calculate the fidelity of RSM the respective PDFs of the spin up and down electron states are first determined. Firstly, the PDF for the spin-up (spin-down) electrons is scaled by the proportion of spin up (down) electrons $N^{\uparrow}(\downarrow)$. Additionally, when in a global magnetic field, the two electron spin states are separated in energy by the Zeeman energy splitting Ez. The energy separation results in the tunnelling transition off the quantum dot 202 to be centred around a different detuning position resulting in an offset (equal to the Zeeman energy) in $\epsilon_0$ for each electron spin state. An example for the PDFs for the spin up and spin down electrons tunnelling off the quantum dot 202 are calculated and presented in Fig. 6A. In particular, Fig. 6A shows probability density functions, $f^{\uparrow}$ and $f^{\downarrow}$ and cumulative density functions, $F^{\uparrow}$ and $F^{\downarrow}$ for the spin-up and spin-down for RSM at B = 2T and $T_e$ = 200 mK ($\gamma_e B/k_B T_e \approx 13.5$) for an electron spin in silicon. The visibility 602 shows a clear peak in between the $f^\uparrow$ and $f^\downarrow$ where the optimal measurement time is indicated by $t_{opt}$.

To determine the measurement fidelity of the RSM using time thresholding, the optimal signal value and time value need to be determined for determining when a $|\uparrow\rangle$ or $|\downarrow\rangle$ is detected. First, with respect to the optimal time threshold $t_{opt}$, the maximal visibility 602 is found when the following condition is met

$$\frac{\partial}{\partial t}\left(V(t_{opt})\right) = 0 = \frac{\partial}{\partial t}\left(F^\uparrow(t_{opt})\right) - \frac{\partial}{\partial t}\left(F^\downarrow(t_{opt})\right) \quad (8)$$

$$0 = f^\uparrow(t_{opt}) - f^\downarrow(t_{opt}) \quad (9)$$

Solving for $t_{opt}$ it is found that

$$t_{opt} = \frac{k_B T_e}{r} \log\left(\frac{X-1}{exp\left(\frac{\epsilon_{\downarrow 0}-E_Z}{k_B T_e}\right) - exp\left(\frac{\epsilon_{\downarrow 0}-E_Z}{k_B T_e}\right)X}\right) \quad (10)$$

where,

$$X = \left(\frac{exp\left(\frac{\epsilon_{\downarrow 0}-E_Z}{k_B T}\right)+1}{exp\left(\frac{\epsilon_{\downarrow 0}}{k_B T}\right)+1}\right)^{\frac{\Gamma k_B T_e - r}{r}} \quad (11)$$

Together, these equations allow the analytic determination of the optimal time threshold and measurement fidelity for a given set of RSM parameters.

In Fig. 6B the measurement visibility (plotted as 1-visibility) and $t_{opt}$ as a function of the ramp rate is shown relative to the electron tunnel rate, $r/\Gamma_0$. Where the electron tunnel rate $\Gamma_0$ is the fastest tunnel rate for a given transition i.e. it is the maximum value that $\Gamma_{in,out}$ and $\Gamma_{out,in}$ saturate at across all detuning values. The longer ramp times show higher fidelity since the electron spin-up state has more time to tunnel out of the electron reservoir before the spin-down state. As r increases, the measurement visibility decreases dramatically since the spin-up state does not have sufficient time to tunnel out to the reservoir 208 before the spin-down state. Accordingly, the optimal measurement time decreases linearly with r since it generally falls within the two probability distributions of the spin-up and spin-down states. Note that a wide range of visibilities can be achieved by varying r such that the speed and visibility of the readout can be readily adjusted in the experiment.

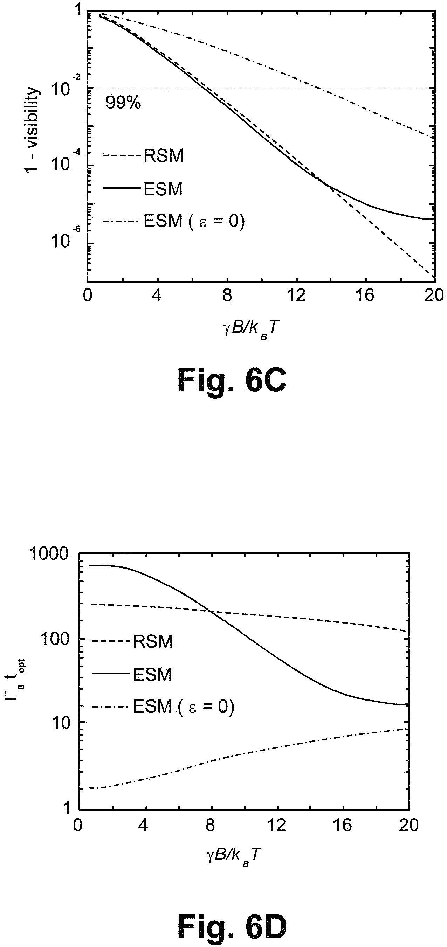

Next, Figs. 6C and 6D show the dependence of the visibility and optimal measurement time for both ESM (optimised detuning and at $\varepsilon = 0$) and RSM (with time threshold optimised and fidelities calculated). As expected, for both methods, the visibility of the readout increases with magnetic field (larger $\gamma_e B_0/k_B T_e$). Ramped spin measurement (RSM) significantly outperforms ESM at $\varepsilon = 0$ where the sensitivity of the readout position to noise is small due to the Fermi distributed tunnel rates of the spin-up and spin-down state. At the optimised detuning position for ESM (which is highly susceptible to charge noise), RSM shows a similar dependence on $\gamma_e B_0/k_B T_e$ and at high magnetic fields ($\gamma_e B_0/k_B T_e$ > 15) RSM outperforms ESM. However, the optimal measurement time for RSM is significantly longer than ESM by a factor ~ 100 at high magnetic fields. To compensate, the readout time of RSM can be reduced to achieve faster readout with a small reduction in the visibility which would bring it in line with the visibility and measurement time achievable with an optimised ESM detuning position. In the experimental device, with optimised ramp rates a state-to-charge conversion fidelity of 99.89 $\pm$ 0.02 % (99.95 $\pm$ 0.01 %) at $B_0 = 1.5$ T ($B_0 = 0.8$ T) with an electron temperature ~ 110 mK corresponding to $E_Z/k_B T \approx 20.1$ ($E_Z/k_B T \approx 9.8$) is obtained.

*Ramped spin initialization*

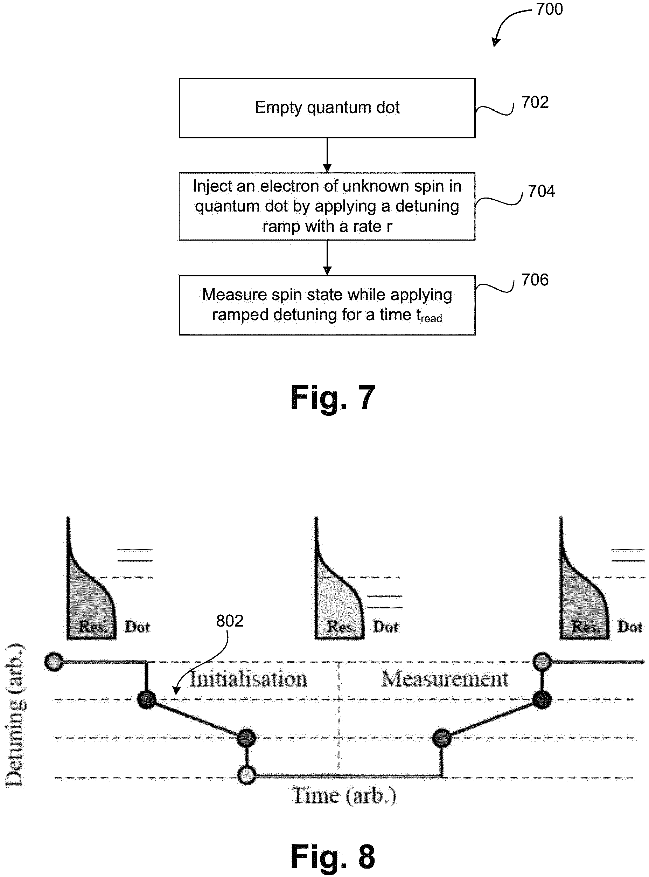

Fig. 7 is a flowchart illustrating an example ramped spin initialization method 700 according to aspects of the present disclosure. The method 700 commences at step 702, where the quantum dot 202 is emptied. Next at step 704, an electron with an unknown spin is injected in the quantum dot 204. Finally, at step 706 the spin state is measured. Much like the RSM method 300, the steps of the RSI method 700 are controlled by applying voltage on a nearby gate 210, which shifts the quantum dot's energy levels around the Fermi level, $E_F$, of the tunnel coupled reservoir 208.

Fig. 8 shows the shape of the voltage pulse applied to the gate. As seen in Fig. 8, the voltage pulse 802 applied during initialization is similar to the voltage pulse applied in the RSM method but in the opposite direction. The quantum dot 202 is first unloaded by applying a voltage for a particular time duration that causes the energy level of the spin up and spin down states of the quantum dot to be higher than the Fermi energy. This causes any electrons in the quantum dot 202 to tunnel to the reservoir 208. Then a detuning ramp 804 with a rate r deterministically loads an electron spin-down. Once the electron is successfully loaded, a constant voltage pulse is applied to maintain the energy levels of the spin up and spin down states of an electron on the quantum dot 202 below the Fermi energy. This prevents the electron on the quantum dot 202 from tunnelling back to the reservoir 208.

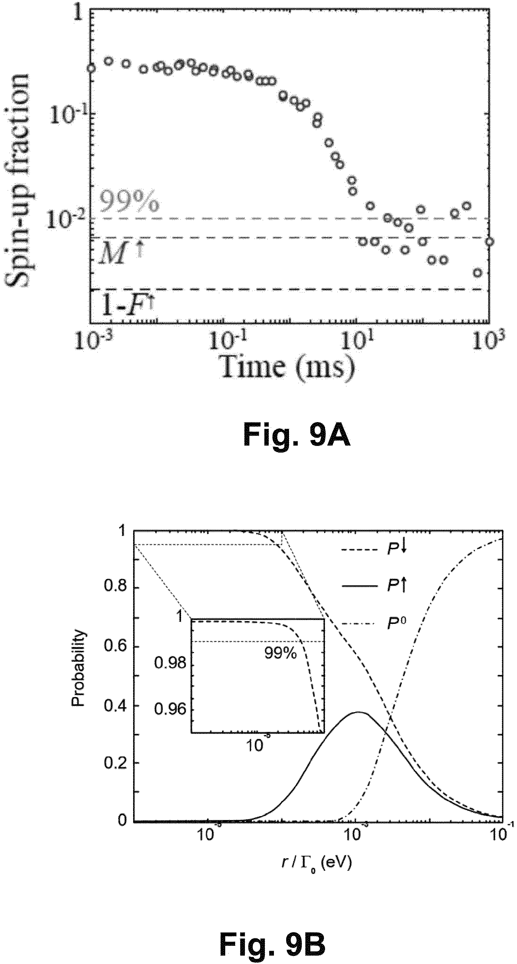

To validate the initialization process, a subsequent RSM method 300 may be performed to measure the spin-up population of the quantum dot 202. In particular, Fig. 9A shows the experimentally measured spin-up fraction as a function of ramp time $t_{ramp}$ for the initialisation protocol. As the initialisation time is increased (that is, decreased ramp rate, r) the spin-up population, $M^\uparrow$, decreases until it reaches a minimum indicated by $M^\uparrow = 0.0064$. That is, as the ramp time becomes large ($r/\Gamma_0 \sim 10^{-4}$) compared to the tunnel in times of the electron then the quantum dot 202 is determin-istically loaded into $|\downarrow\rangle$. From previous calibration of the measurement fidelity and $M^\uparrow$, the initialisation fidelity can be estimated using Eq. 13 below. Interestingly, the relative population of the two spin states can be controlled continuously from $\sim 50\%$ to $\sim 0\%$ by changing the ramp time ($r/\Gamma_0 \sim 10^{-3}$ to $r/\Gamma_0 \sim 10^{-5}$), which could be used for initialising different spin states.

Initialisation fidelity, $F_{init}$ can be defined as the accuracy at which an electron can be deterministically initialised in a spin-down state $|\downarrow\rangle$. To accurately determine $F_{init}$ the measurement fidelity is taken into account since that contributes to the number of spin-up states that can be correctly identified. The experimentally measured spin-up count, $M^\uparrow$ is given by,

$$M^\uparrow = \left(1 - F^{init}\right)F^\uparrow + F^{init}\left(1 - F^\downarrow\right) \qquad (12)$$

which can be rearranged to obtain,

$$F^{init} = \frac{F^\uparrow}{F^\uparrow - F^\downarrow + 1} M^\uparrow \qquad (13)$$

Using the data from Fig. 9A and $F^\uparrow = 0.9979$, $F^\downarrow = 0.9955$, and $M^\uparrow = 0.0064$ at $B_0 = 2T$ we find $F^{init} = 0.9891$ close to the 99% error threshold for fault-tolerant surface-code algorithms.

Fig. 9B shows the final spin probabilities after the ramped initialisation as a function of the relative ramp rate $r/\Gamma_0$. For large r ($r/\Gamma_0 > 10^{-2}$) the electron does not have enough time to tunnel from the reservoir 208 to the quantum dot 202 and therefore the probability of no electron being initialised, $P^0$ remains high. For intermediate ramp rates ($r/\Gamma_0 \sim 10^{-3}$) both the spin-up and spin-down electron have approximately equal occupation probabilities with $P^\uparrow \approx P^\downarrow$. Finally, for slow ramp rates ($r/\Gamma_0 < 10^{-4}$) the electron spin-down state is predominately occupied since the spin-up state does not have sufficient time to tunnel onto the quantum dot 2020. By varying r a range of different mixed spin states can be initialised.

The expected initialisation fidelity $F^{init}$ can also be theoretically calculated for a range of $t_{ramp}$ values using the previously derived PDF (Equation 3) and the experimental fit parameters. The relevant electron tunnelling rates between the reservoir 208 and quantum dot 202 for initialisation are the complement of the relevant tunnelling rates for readout. This symmetry means that both initialisation and readout can be described by the same NHP process as long as a polarity change is made to the detuning axis. Therefore, $f^{\uparrow/(\downarrow)}(t)$ describes the PDF of a single spin up (down) electron tunnelling from the reservoir 208 to the quantum dot 202.

The biggest difference between the two processes is that initialisation involves many possible electrons in the reservoir of which only one (or none) is initialised onto the quantum dot. To account for this difference when calculating the probability of initialising a spin-up (down) electron $P^{\uparrow/(\downarrow)}_{init}(t)$, the probability that an electron of the opposite spin had not already tunnelled onto the quantum dot must be considered. Hence,

$$P^{\uparrow/(\downarrow)}_{init}(t) = f^{\uparrow/(\downarrow)}(t)\left(1 - \int_0^t f^{\uparrow/(\downarrow)}(t')dt'\right) \qquad (14)$$

$$= f^{\uparrow/(\downarrow)}(t)\left(1 - F^{\uparrow/(\downarrow)}(t)\right) \qquad (15)$$

where the initialisation fidelity is equal to the total probability that a spin down electron was initialised within the ramp time, i.e.,

$$F^{init} = \int_0^{t_{ramp}} P_{init}^{\uparrow}(t)dt. \qquad (16)$$

Using Equation 16 it is possible to predict the required ramp time to initialise a certain level of initialisation fidelity given a set of experiment parameters.

Accordingly, aspects of the present disclosure propose and demonstrate a readout technique for semiconductor spin qubits that can be used to measure the spin of qubits in currently implemented and future implementations of quantum processing/computing systems. The readout protocol offers a number of advantages over known readout techniques including simple alignment (with feedback), short measurement/initialisation times, and reduced gate bandwidths.

Using the measurement technique, the present disclosure shows that high-fidelity readout can be readily performed at low magnetic field to temperature ratios, which is crucial for high temperature qubit operation. Finally, the reverse pulse sequence can be used to deterministically load the $|\downarrow\rangle$ with greater than 99% fidelity or controllably load a particular mixture of $|\downarrow\rangle$ and $|\uparrow\rangle$ states. The RSM advantages over ESM will allow for simple single-shot, low magnetic field measurements that can be readily scaled to large qubit systems.

*Ramped Readout with two quantum dots*

In the previous sections, the ramped initialization and readout methods were described with respect to a quantum dot and a reservoir - i.e., based on tunnel coupling between a quantum dot and a reservoir. These ramped methods can be extended to include spin-state selective readout between pairs of quantum dots.

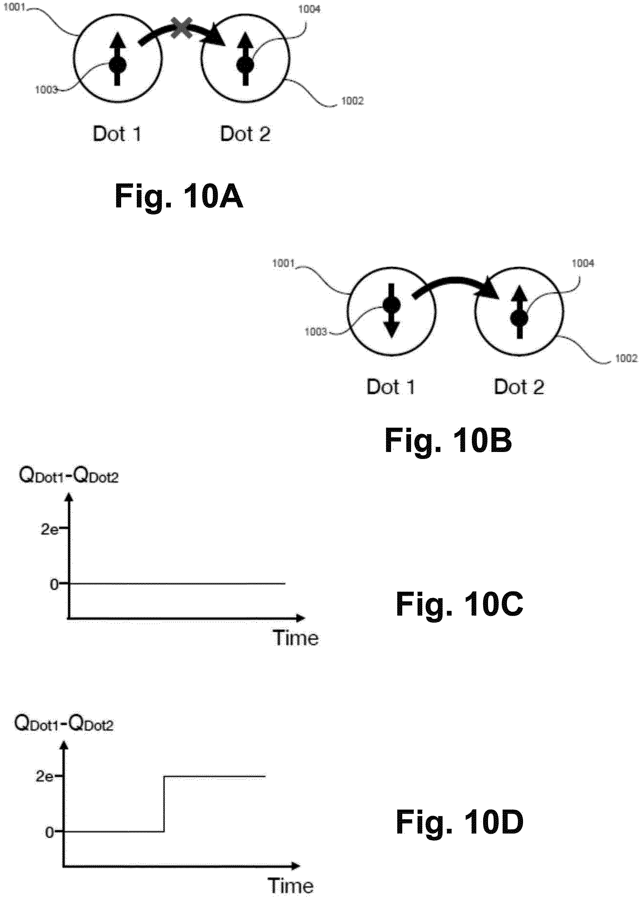

Figs. 10A and 10B illustrates the principles of spin state selective tunnelling between two quantum dots that uses a conventional single-shot readout technique is referred to as Pauli spin blockade measurement (PSB).

In both Figs. 10A and 10B, there are two quantum dots 1001 and 1002 that are tunnel coupled to one another. Each quantum dot has an unpaired electron 1003 and 1004. For such interacting qubits there are four possible combined spin states. Each electron has two possible spin states, spin-down and spin-up, denoted $|\downarrow\rangle$ and $|\uparrow\rangle$, respectively. Combining the two spin states of each electron yields four new states. There is one singlet state with total spin angular momentum 0. This state is:

$$|S\rangle = \frac{1}{\sqrt{2}}(|\uparrow\downarrow\rangle - |\downarrow\uparrow\rangle)$$

Where the first arrow and second arrow in each combination indicate the spin direction of the first and second electron 1003, 1004 respectively. There are three triplet states, each with total spin angular momentum 1:

$$|T_+\rangle = |\uparrow\uparrow\rangle$$

$$|T_0\rangle = \frac{1}{\sqrt{2}}(|\uparrow\downarrow\rangle + |\downarrow\uparrow\rangle)$$

$$|T_-\rangle = |\downarrow\downarrow\rangle.$$

Here, the $T_+$ triplet state corresponds to both electrons 1003, 1004 being in the spin-up state and the $T_-$ triplet state corresponds to both electrons 1003, 1004 being in the spin-down state.

In Fig. 10A the electrons 1003, 1004 are shown in a triplet-plus $|T_+\rangle = |\uparrow\uparrow\rangle$ state. In this case, no tunnelling is permitted. That is, electron 1003 cannot move to quantum dot 1002 and thus will remain on quantum dot 1001. There is also no tunnelling allowed if the electrons occupy the other triplet states: $|T_-\rangle = |\downarrow\downarrow\rangle$ or $|T_0\rangle = |\uparrow\downarrow\rangle + |\downarrow\uparrow\rangle$. Fig. 10C is a chart showing the charge difference of the quantum dots 1001 and 1002 as a function of time as detected by a nearby charge sensor. As the electron 1003 does not tunnel from quantum dot 1001 to 1002, there is no charge difference between the quantum dots even when the quantum dot potentials are tuned.

In Fig. 10B the electrons are in the singlet state - $|S\rangle = |\uparrow\downarrow\rangle - |\downarrow\uparrow\rangle$. In this state, when the potential of quantum dot 1002 is detuned below the potential of quantum dot 1001, the electron 1003 can tunnel to quantum dot 1002 as the spin states of the electrons on the two quantum dots are opposite.

Fig. 10D is a chart showing the charge difference of the quantum dots 1001 and 1002 as a function of time as detected by a nearby charge sensor. As seen in this chart, the charge difference between the two dots is zero for a period of time. But when the dot potential is tuned, the electron 1003 tunnels to quantum dot 1002, causing a difference in the charge state of the two dots - as one quantum dot now has two electrons and the other quantum dot has no electrons. In this manner, the quantum state is correlated with the charge state, and measurement of the charge on the dot reveals the original quantum state.

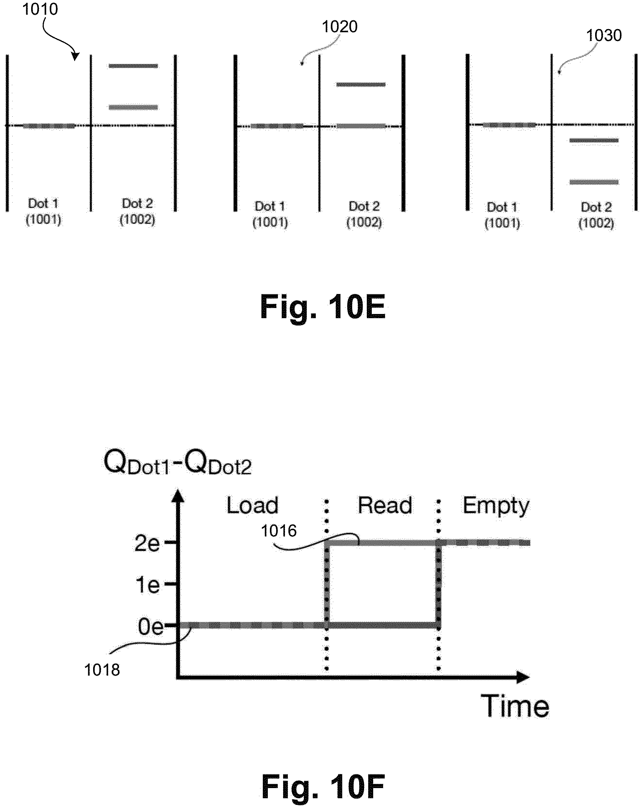

In some cases, to measure the state of a qubit using PSB, a three stage process (as shown in Fig. 10E) is used that includes: a first stage 1010 in which both electrons 1003 and 1004 are in quantum dot 1001 as a singlet state (load stage), a second stage 1012 in which one electron 1003 is rapidly moved from quantum dot 1001 to quantum dot 1002 resulting in an unknown spin state (either Singlet or Triplet-0) (Read stage); and a third stage 1014 in which the spin state is measured (using a nearby charge sensor) (empty stage).

The different stages are typically controlled by a three-level voltage pulse on nearby gate(s). The voltage pulse shifts the quantum dots' energy levels relative to each other. The shape of the voltage pulse in this case is the same as that shown in Fig. 1E.

Before a pulse is applied, both electrons 1003, 1004 are in quantum dot 1001. The electrons can either be in the Singlet, $|S(0,2)\rangle$, or Triplet-0 , $|T_0(0,2)\rangle$, states. After sufficient time, the Triplet-0 state relaxes to the Singlet ground state.

Then at the second stage a voltage pulse (called the load phase) is applied for time $t_{wait}$. This pulse pulls the energy levels of both spin states below the fermi energy $E_F$. An electron 1003 can now energetically tunnel into the dot 1002 from the reservoir 106. The quantum state of the electrons 1003 and 1004 after the tunnelling can either be a Singlet or a Triplet-0 state.

During this stage 1010, the electron 1003 (1004) is trapped on the dot 1001 (1002) and the Coulomb blockade prevents a second electron from being added to the dots 1001(1002).

After $t_{wait}$, the voltage pulse is increased and maintained for a duration $t_{read}$, in order to position the energy levels of the Singlet and Triplet-0 states in a read-out configuration.

If the quantum state is Singlet, then the electrochemical potential of the Singlet states with one electron in each dot 1001 and 1002, $|S(1,1)\rangle$, and with two electrons in 1002, $|S(0,2)\rangle$, are equal, so the electron 1003 can tunnel between dots 1001 and 1002. If the quantum state is one of the triplet states, e.g., $|T_0\rangle$, the electrochemical potential of the Triplet-0 state with one electron in each quantum dot 1001 and 1002, $|T_0(1,1)\rangle$, is lower than of the Triplet-0 state with two electrons in quantum dot 1002, $|T_0(0,2)\rangle$, so the electron 1001 remains on quantum dot 1001 - no tunnelling occurs.

After $t_{read}$, the pulse ends and the Triplet-0 state relaxes to the Singlet state again. In the read phase, the voltage pulse quickly moves $S_{11}$ and $S_{02}$ such that they are equal. At this voltage level if the electrons 1003 and 1004 are in a Singlet state then the position of electron 1003 becomes a superposition of being in quantum dot 1001 and 1002.

This superposition creates a 'step' in a nearby charge sensor response which is a signature that state-to-charge conversion of the quantum state has been performed. Fig. 10F shows the signal from a nearby sensor during PSB. During the read phase 1016, the singlet state is detected as a characteristic 'step' 1016 in the charge sensor signal 1018.

Aspects of the present disclosure provide a new method to perform readouts between two quantum dots. This method is more resilient to charge noise, high-temperatures, and low magnetic field operation. Further, this method can be easier to scale to a larger number of qubits compared to ESM.

Fig. 4A shows the shape of the voltage pulse 400 applied to the gate 210 during the presently disclosed RSM method 1100. As seen in Fig. 4A, the voltage pulse 400 is similar to the voltage pulse applied in the PSB method during the load and empty stages. However, during the read phase, instead of pulsing the voltage to a single detuning value and checking if the dot occupation changes, the detuning is ramped 402 from below the Fermi energy $E_F$ to above the Fermi energy $E_F$.

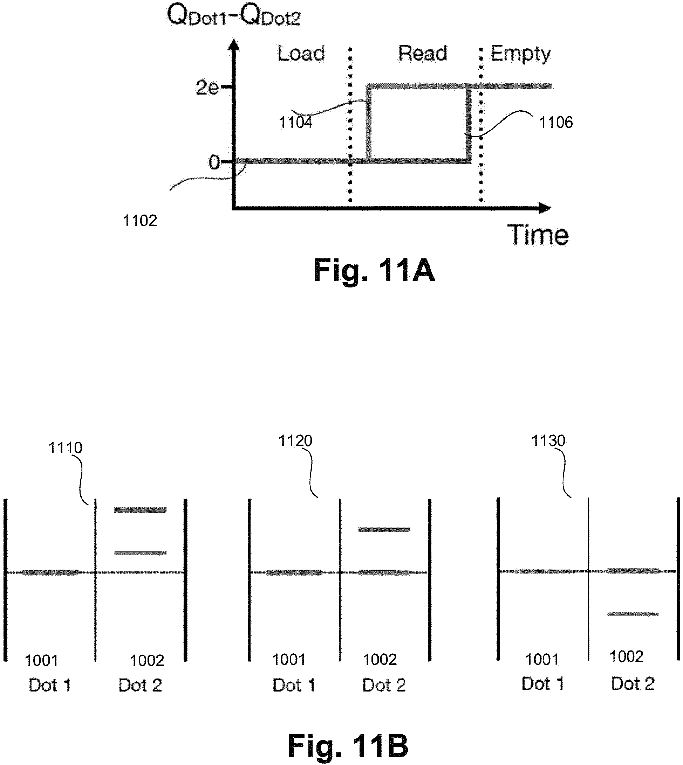

Further, the load stage and empty stage are equivalent to the load and empty stages of the PSB method. However, the read phase now involves determining when a step occurs during the read phase rather than if a step is detected. Fig. 11A shows the charge difference between quantum dots 1001 and 1002 during RSM. A step in the charge sensor signal 1102 before a certain threshold time (see step 1104) indicates the presence of a Singlet state in quantum dots 1001 and 1002, whereas a step in the charge sensor signal 1102 after the threshold time (see step 1106) indicates the presence of a Triplet-0 state in quantum dots 1001 and 1002. Further, the charge sensor signal 1102 reaches its maximum value before the empty phase as the electron 1003 in quantum dot 1001 always tunnels to quantum dot 1002 during the read phase.

Further still, in the RSM technique, the time threshold is redefined. For PSB, the time threshold is equivalent to the readout time and is chosen to determine if a step 1016 is detected. If a step is detected, the qubit state is assigned to be in the | S) state, whereas if no step is detected before the time threshold then the qubit state is assigned to be | $T_0\rangle$. However, for RSM, the time threshold is used to determine when a step occurs. If step 1104 is detected before the time threshold then the qubit state is assigned to be | S) and if the step 1106 occurs after the threshold, then the qubit state is assigned as | $T_0\rangle$.

The optimal time threshold $t_{opt}$ scales proportionately with $\Gamma_0$. For a given device and parameter values one can find the non-homogeneous Poisson distributions for each spin state (up and down). As such, $t_{opt}$ is then the time threshold that distinguishes between these 2 distributions with the optimal fidelity.

In order to measure the state of a qubit using this method, a three stage process (as shown in Fig. 11B - similar to Fig. 10E) is used that includes: a first stage 1110 in which both electrons 1003 and 1004 are in quantum dot 1001 as a singlet state (load stage), a second stage 1120 in which one electron 1003 is rapidly moved from quantum dot 1001 to quantum dot 1002 resulting in an unknown spin state (either Single to Triplet-0) (Read stage); and a third stage 1130 in which the spin state is measured (using a nearby charge sensor) (empty stage).

Since the electrochemical potentials of | $S$ (1,1)) and | $T_0$ (1,1)) spin states are above those of |$S$(0,2)) and |$T_0$ (1,1)⟩⟩ at the end of the ramp 401, a step 1104 or 1106 is always detected in the charge sensor signal during the read phase; that is, the quantum state has to be in either | $T_0$) or | S). That is, the spin state may be measured at step 1130.

Finally, the use of ramp pulses 1202 significantly reduces the bandwidth requirements for fast pulsing which could possibly lead to lower electron temperatures since additional filtering can be implemented.

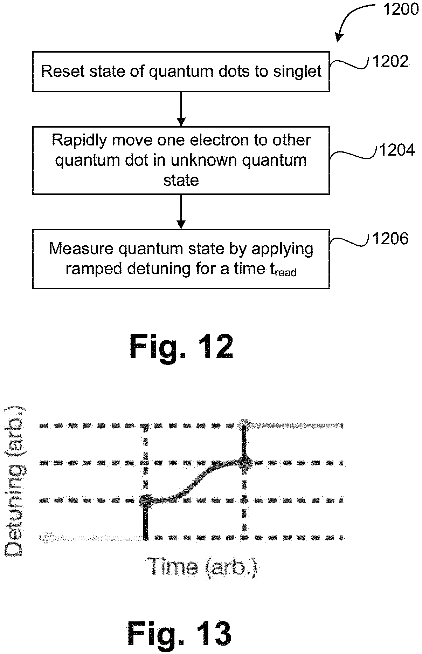

Fig. 12 is a flowchart illustrating an example method 1200 for measuring spin qubits based on the ramped spin measurement method of the present disclosure. Like the PSB method, the RSM method 1100 includes three steps. The method commences in the (0, 1) charge state - where quantum dot 1002 includes an unpaired electron whereas quantum dot 1001 includes zero unpaired electrons. An electron is then loaded into the right quantum dot, 1002, leading to a singlet ground state S (0,2) at step 1202.

At step 1204, the detuning between the dots is changed across the (0,2) → (1,1) transition, allowing one electron 1003 to tunnel from the right quantum dot to the left quantum dot resulting in the electrons having an unknown quantum state | $S$ (1,1)) or |$T_0$ (1,1)⟩.

Next, at step 1206, the quantum state of the electrons 1003 and 1004 is measured by applying a ramped voltage. If a step is detected in the charge difference between the two dots before a threshold period of time, it is determined that the quantum dots were in the | $S$ (1, 1)) state and if the step 1106 is detected in the charge difference between the two dots after a threshold period of time, then it is determined that the quantum dots were in the |$T_0$(1,1)⟩ state. These steps of the RSM method 1200 are controlled by applying voltage on a nearby gate 210, which shifts the energy levels of the quantum dots 1001 and 1002 around each other. The time threshold at which any events that occur before it during readout are assigned to the singlet state, and any time after the time threshold are assigned to a triplet.

Fig. 4A and 12A both show a linear ramping voltage. However, it will be appreciated that the ramping voltage need not be linear. Instead, the ramping voltage can also be a non-linear voltage. In this case, the optimal threshold period of time may be different. Fig. 13 shows an example non-linear ramping voltage as part of a RSM applied to initial a qubit or read the state of a qubit or a pair of qubits.

The term "comprising" (and its grammatical variations) as used herein are used in the inclusive sense of "having" or "including" and not in the sense of "consisting only of".

It will be appreciated by persons skilled in the art that numerous variations and/or modifications may be made to the invention as shown in the specific embodiments without departing from the spirit or scope of the invention as broadly described. The present embodiments are, therefore, to be considered in all respects as illustrative and not restrictive.

## Claims

1. A method for measuring the spin of an injected electron in a quantum dot that is tunnel coupled to a reservoir, the method comprising:
   measuring a spin state of the injected electron while applying a ramped detuning for a time period.

2. The method of claim 1, further comprising:

   emptying the quantum dot; and/or
   injecting the electron in the quantum dot by applying a constant voltage pulse for a first time period.

3. The method of any one of claims 1-2, wherein applying the ramped detuning comprises continuously ramping electrochemical potentials of the spin states of the injected electron from below Fermi energy of the reservoir to above the Fermi energy of the reservoir.

4. The method of any one of claims 1-3, wherein measuring the spin state of the injected electron comprises monitoring a charge signal of the quantum dot using a charge sensor; and wherein:

> a blip in the charge signal of the quantum dot before a threshold time indicates a spin-up state of the injected electron; and
> an increase in the charge signal of the quantum dot after a threshold time indicates a spin-down state of the injected electron.

5. The method of any of the preceding claims, wherein a rate for the injected electron to tunnel out of the quantum dot and into the reservoir increases during the time period and a rate for an electron to tunnel from the reservoir to the quantum dot decreases during the time period.

6. A method for measuring the spin of an electron in a first quantum dot that is tunnel coupled to a quantum element, the method comprising:
measuring a quantum state of the first quantum dot while applying a ramped detuning for a time period.

7. The method of claim 6, wherein the quantum element is a reservoir and measuring the quantum state of the first quantum dot includes measuring a spin state of the electron.

8. The method of claim 6, wherein the quantum element is a second quantum dot, and measuring the quantum state of the first quantum dot comprises also measuring the quantum state of the second quantum dot.

9. The method of claim 8, further comprising injecting an electron in the second quantum dot to set the state of the quantum dots to a singlet state such that the first quantum dot includes zero unpaired electrons and the second quantum dot includes two electrons by applying a constant voltage pulse for a first time period.

10. The method of any one of claims 8-9, wherein applying the ramped detuning comprises continuously ramping electrochemical potentials of the spin states of the injected electron from below Fermi energy to above the Fermi energy.

11. The method of any one of claims 8-10, wherein measuring the quantum state of the first and second quantum dots comprises monitoring a charge difference between the first and second quantum dots using a charge sensor, and wherein:

> a step in the charge difference between the quantum dots before a threshold time indicates a singlet quantum state; and
> an increase in the charge difference between the quantum dots after a threshold time indicates a triplet zero quantum state.

12. The method of any of claims 8-11, wherein a rate for the injected electron to tunnel out of the second quantum dot and into the first quantum dot increases during the time period.

13. A method for initializing a spin qubit in a quantum dot that is tunnel coupled to a reservoir, the method comprising:
injecting an electron in the quantum dot by applying a ramped detuning for a first time period.

14. The method of claim 13, further comprising:

> emptying the quantum dot; and/or
> measuring a spin state of the injected electron while applying a ramped detuning for a second time period.

15. The method of any one of claims 13-14, wherein applying the ramped detuning for the first time period comprises continuously ramping electrochemical potentials of the spin states of the injected electron from above Fermi energy of the reservoir to below the Fermi energy of the reservoir.

**Fig. 1A**

**Fig. 1B**

**Fig. 1C**

**Fig. 1D**

**Fig. 1E**

**Fig. 1F**

**Fig. 1G**

**Fig. 2**

300

| Empty quantum dot | 302 |

↓

| Inject an electron of unknown spin in quantum dot by applying a voltage pulse for a time $t_{load}$ | 304 |

↓

| Measure spin state while applying ramped detuning for a time $t_{read}$ | 306 |

# Fig. 3

401

400

Detuning (arb.)

Time (arb.)

# Fig. 4A

404

LOAD    READ    EMPTY

Signal (arb.)

402

Time (arb.)

# Fig. 4B

**Fig. 5A**

**Fig. 5B**

**Fig. 5C**

**Fig. 5D**

**Fig. 6A**

**Fig. 6B**

**Fig. 6C**

**Fig. 6D**

700

Empty quantum dot 702

Inject an electron of unknown spin in quantum dot by applying a detuning ramp with a rate r 704

Measure spin state while applying ramped detuning for a time $t_{read}$ 706

# Fig. 7

Fig. 8

**Fig. 9A**

**Fig. 9B**

Fig. 10A

Fig. 10B

Fig. 10C

Fig. 10D

1010

1020

1030

| Dot 1 (1001) | Dot 2 (1002) | Dot 1 (1001) | Dot 2 (1002) | Dot 1 (1001) | Dot 2 (1002) |

## Fig. 10E

$Q_{Dot1} - Q_{Dot2}$

Load    Read    Empty

1016

2e

1e

0e

1018

Time

## Fig. 10F

$Q_{Dot1}-Q_{Dot2}$

Load ⋮ Read ⋮ Empty

2e

1104

1106

0

1102

Time

**Fig. 11A**

1110

1120

1130

1001
Dot 1

1002
Dot 2

1001
Dot 1

1002
Dot 2

1001
Dot 1

1002
Dot 2

**Fig. 11B**

1200

| Reset state of quantum dots to singlet | 1202 |

| Rapidly move one electron to other quantum dot in unknown quantum state | 1204 |

| Measure quantum state by applying ramped detuning for a time $t_{read}$ | 1206 |

# Fig. 12

Detuning (arb.)

Time (arb.)

# Fig. 13

Europäisches
Patentamt

European
Patent Office

Office européen
des brevets

# EUROPEAN SEARCH REPORT

Application Number

EP 22 21 4997

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FOGARTY M A ET AL: "Integrated silicon qubit platform with single-spin addressability, exchange control and robust single-shot singlet-triplet readout", ARXIV.ORG, CORNELL UNIVERSITY LIBRARY, 201 OLIN LIBRARY CORNELL UNIVERSITY ITHACA, NY 14853, 11 August 2017 (2017-08-11), XP081404786, DOI: 10.1038/S41467-018-06039-X | 1-3,5-15 | INV. G06N10/40 |
| Y | * page 1 – page 8, left-hand column, paragraph 1 * | 4 | |
| Y | KEITH D ET AL: "Benchmarking high fidelity single-shot readout of semiconductor qubits", NEW JOURNAL OF PHYSICS, INSTITUTE OF PHYSICS PUBLISHING, BRISTOL, GB, vol. 21, no. 6, 11 June 2019 (2019-06-11), page 63011, XP020334851, ISSN: 1367-2630, DOI: 10.1088/1367-2630/AB242C [retrieved on 2019-06-11] | 4 | |
| A | * page 1 – page 17, paragraph 1 * | 1-3,5-15 | |
| A | SCHAAL S ET AL: "A CMOS dynamic random access architecture for radio-frequency readout of quantum devices", ARXIV.ORG, CORNELL UNIVERSITY LIBRARY, 201 OLIN LIBRARY CORNELL UNIVERSITY ITHACA, NY 14853, 11 September 2018 (2018-09-11), XP081357515, DOI: 10.1038/S41928-019-0259-5 * the whole document * | 1-15 | |

TECHNICAL FIELDS
SEARCHED      (IPC)

G06N

–/––

The present search report has been drawn up for all claims

| Place of search | Date of completion of the search | Examiner |
|---|---|---|
| The Hague | 20 April 2023 | Volkmer, Markus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt
European
Patent Office
Office européen
des brevets

## EUROPEAN SEARCH REPORT

Application Number

EP 22 21 4997

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2020/188241 A1 (QUANTUM MOTION TECH LIMITED [GB]; UNIV OXFORD INNOVATION LTD [GB]) 24 September 2020 (2020-09-24) * the whole document * ----- | 1-15 | |
| X,P | KEITH DANIEL ET AL: "Ramped measurement technique for robust high-fidelity spin qubit readout", SCIENCE ADVANCES, vol. 8, no. 36, 7 September 2022 (2022-09-07), pages 1-8, XP093039180, DOI: 10.1126/sciadv.abq0455 * the whole document * ----- | 1-15 | |

TECHNICAL FIELDS
SEARCHED      (IPC)

The present search report has been drawn up for all claims

| Place of search | Date of completion of the search | Examiner |
|---|---|---|
| The Hague | 20 April 2023 | Volkmer, Markus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 2 of 2

## ANNEX TO THE EUROPEAN SEARCH REPORT
## ON EUROPEAN PATENT APPLICATION NO.

EP 22 21 4997

This annex lists the patent family members relating to the patent documents cited in the above-mentioned European search report.
The members are as contained in the European Patent Office EDP file on
The European Patent Office is in no way liable for these particulars which are merely given for the purpose of information.

20-04-2023

| Patent document cited in search report | | Publication date | Patent family member(s) | | Publication date |
|---|---|---|---|---|---|
| WO 2020188241 | A1 | 24-09-2020 | EP | 3942485 A1 | 26-01-2022 |
| | | | TW | 202101309 A | 01-01-2021 |
| | | | US | 2022156629 A1 | 19-05-2022 |
| | | | WO | 2020188241 A1 | 24-09-2020 |